(19) Europäisches Patentamt
European Patent Office
Office européen des brevets

(11) **EP 2 017 630 A2**

(12) **EUROPÄISCHE PATENTANMELDUNG**

(43) Veröffentlichungstag:
**21.01.2009 Patentblatt 2009/04**

(51) Int Cl.:
***G01R 19/08*** *(2006.01)*

(21) Anmeldenummer: 08159477.2

(22) Anmeldetag: **02.07.2008**

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**
Benannte Erstreckungsstaaten:
**AL BA MK RS**

(30) Priorität: **16.07.2007 DE 102007034699**

(71) Anmelder: **Deutsches Zentrum für Luft- und Raumfahrt e.V.**
**51147 Köln (DE)**

(72) Erfinder:
• **Schönbauer, Stefan**
**70197, Stuttgart (DE)**
• **Sander, Heinz**
**74189, Weinsberg (DE)**

(74) Vertreter: **Hoeger, Stellrecht & Partner**
**Patentanwälte**
**Uhlandstrasse 14 c**
**70182 Stuttgart (DE)**

(54) **Messvorrichtung und Verfahren zur Ermittlung des elektrischen Potentials und/oder der Stromdichte an einer Elektrode**

(57) Es wird eine Messvorrichtung zur Ermittlung des elektrischen Potentials und/oder der Stromdichte an einer Elektrode bereitgestellt, umfassend eine elektrische Kontakteinrichtung, welche die Elektrode kontaktiert, eine erste Gruppe von elektrischen Kontaktelementen aufweist, die in einer ersten Messfläche verteilt angeordnet sind und über welche die elektrische Potentialverteilung an der ersten Messfläche messbar ist, mindestens eine zweite Gruppe an elektrischen Kontaktelementen aufweist, welche in einer zweiten Messfläche verteilt angeordnet sind und über die die elektrische Potentialverteilung an der zweiten Messfläche messbar ist, wobei die erste Messfläche und die zweite Messfläche beabstandet zueinander sind, und eine Auswertungseinrichtung, mit der auf Grundlage der elektrischen Potentialtheorie aus den gemessenen Potentialen die elektrische Potentialverteilung und/oder Stromdichteverteilung an der Elektrode bestimmbar ist.

**Fig. 1**

**Beschreibung**

Die Erfindung betrifft eine Messvorrichtung zur Ermittlung des elektrischen Potentials und/oder der Stromdichte an einer Elektrode.

Die Erfindung betrifft weiterhin eine Elektroden-Messvorrichtung-Kombination.

Ferner betrifft die Erfindung eine Brennstoffzelle und einen Brennstoffzellenstapel.

Weiterhin betrifft die Erfindung ein Verfahren zur Bestimmung der elektrischen Potentialverteilung und/oder der Stromdichteverteilung an einer Elektrode.

Um die Lebensdauer und Betriebszuverlässigkeit einer Elektrode, wie sie beispielsweise in einer Brennstoffzelle eingesetzt wird, zu erhöhen, ist es notwendig, diese zu überwachen und gegebenenfalls das Elektrodensystem zu steuern oder zu regeln.

Aus der DE 101 51 601 B4 ist ein Gasverteilungselement zur Reaktionsgaszuführung zu einer oder mehreren elektrochemischen Elektroden bekannt, welches mit Gasräumen versehen ist. In das Gasverteilungselement ist eine Messplatine integriert, welche eine Mehrzahl von Messsegmenten aufweist, über die eine lokale Stromverteilung messbar ist. Zur elektrischen Kontaktierung einer Elektrode ist eine Mehrzahl von Stromableitungselementen vorgesehen, über die elektrische Ströme in Normalenrichtung zu der Messplatine ableitbar sind.

Aus der DE 103 16 117 B3 ist eine Messvorrichtung zur Messung der lokalen Stromverteilung/Wärmeverteilung an einer elektrochemischen Elektrode bekannt, welche eine Mehrzahl von Messsegmenten umfasst. Ein Messsegment weist ein Widerstandselement auf und weist mindestens ein Stromableitungselement auf, über welches die elektrochemische Elektrode kontaktierbar ist und eine Stromableitung zu dem zugeordneten Widerstandselement erfolgt. Das einem Messsegment zugeordnete Widerstandselement ist so orientiert, dass der Stromfluss an diesem Widerstandselement in eine Richtung quer zu der Stromflussrichtung an dem Stromleitungselement erfolgt.

Aus der EP 1 254 376 B1 ist ein Verfahren zur Bestimmung der Stromdichteverteilung in einem Brennstoffzellenstack bekannt, bei dem die Stromdichteverteilung aus dem den Stack umgebenden, vom Stromfluss im Stack erzeugten Magnetfeld bestimmt wird.

Aus der DE 197 50 738 C1 ist ein Verfahren zur Bestimmung des Stoffumsatzes bei flächenhaft ablaufenden elektrochemischen Reaktionen in mindestens einem lokalen Flächenbereich zwischen einer flächenhaft ausgebildeten Gegenelektrodenanordnung und einer flächenhaft ausgebildeten Elektrodenanordnung, welche ein dem Flächenbereich entsprechend ausgebildetes Kontaktelementsegment und ein die übrigen Flächenbereiche kontaktierendes und gegenüber dem Kontaktelementsegment elektrisch isoliertes Kontaktelement aufweist, bekannt. Sowohl das Kontaktelement als auch das Kontaktelementsegment werden mit einer für das Betreiben der elektrochemischen Reaktion vorgesehenen Stromquelle oder Stromsenke verbunden, zwischen dem Kontaktelementsegment und der Stromquelle oder Stromsenke wird über einen Leiter fließender Strom um den Leiter herum ein Magnetfeld erzeugt und das Magnetfeld wird als Maß für den Stoffumsatz in dem lokalen Flächenbereich bestimmt.

Aus der DE 102 13 478 A1 ist ein Verfahren zur Messung der Stromdichteverteilung oder des ortsaufgelösten Stoffumsatzes bei elektrochemischen Reaktionen bekannt, bei dem eine der Elektroden in gegeneinander isolierte Segmente aufgeteilt wird und jedes Segment mit einer eigenen für den Betrieb der elektrochemischen Reaktion vorgesehenen Stromquelle oder Stromsenke verbunden wird, die aus einer integrierten Schaltung besteht, die als Konstantspannungsquelle geschaltet wird.

Aus der DE 102 13 479 A1 ist ein Verfahren zur Messung der Stromdichteverteilung bekannt, bei dem der zu messende Strom durch je eine Spule auf zwei getrennten, sich nicht beeinflussenden, Kernen aus weichmagnetischem Material fließt.

Aus der JP 61264683 ist eine Vorrichtung zum Messen der Stromverteilung auf einer Elektrode, welche Teil einer Brennstoffzelle ist, bekannt. Es wird dabei eine Potentialdifferenz zwischen einem Paar von Potentialmesspunkten gemessen.

Aus der DE 24 51 961 A1 ist ein Verfahren und ein System zur Fernübertragung von Informationen durch den Erdboden oder unter Wasser bekannt.

Der Erfindung liegt die Aufgabe zugrunde, eine Messvorrichtung der eingangs genannten Art bereitzustellen, welche auf einfache Weise aufgebaut ist.

Diese Aufgabe wird erfindungsgemäß dadurch gelöst, dass die Messvorrichtung eine elektrische Kontakteinrichtung umfasst, welche die Elektrode kontaktiert, eine erste Gruppe von elektrischen Kontaktelementen aufweist, die in einer ersten Messfläche verteilt angeordnet sind und über welche die elektrische Potentialverteilung an der ersten Messfläche messbar ist, mindestens eine zweite Gruppe an elektrischen Kontaktelementen aufweist, welche verteilt in einer zweiten Messfläche verteilt angeordnet sind und über die die elektrische Potentialverteilung an einer zweiten Messfläche messbar ist, wobei die erste Messfläche und die zweite Messfläche beabstandet zueinander sind, und eine Auswertungseinrichtung umfasst, mit der auf Grundlage der elektrischen Potentialtheorie aus den gemessenen Potentialen die elektrische Potentialverteilung und/oder Stromdichteverteilung an der Elektrode bestimmbar ist.

Bei der erfindungsgemäßen Messvorrichtung wird die elektrische Potentialverteilung in der ersten Messfläche und in der zweiten Messfläche der elektrischen Kontakteinrichtung gemessen. Mit Hilfe der elektrischen Potentialtheorie wird dann aus den gemessenen Potentialdaten die Potentialverteilung an der der Elektrode zugewandten Fläche, der Kontaktfläche zur Elektrode, berechnet. Eine Messfläche kann dabei eine Oberfläche der elektrischen Kontakteinrichtung sein oder im Inneren der elektrischen Kontakteinrichtung liegen. Wenn die Potentialverteilung an der Kontaktfläche der elektrischen Kontakteinrichtung bekannt ist (durch direkte Messung oder auf Grundlage der Potentialtheorie aus den Potentialdaten an der ersten Messfläche und der zweiten Messfläche), dann lässt sich die Stromdichteverteilung berechnen.

Prinzipiell ist es günstig, wenn mindestens eine Messfläche möglichst nahe an der Kontaktfläche der elektrischen Kontakteinrichtung liegt. Dadurch lässt sich die Potentialverteilung und Stromdichteverteilung an der Kontaktfläche besonders gut bestimmen. Zwischen der Kontaktfläche der elektrischen Kontakteinrichtung und der eigentlichen Elektrodenfläche kann dabei eine Gasdiffusionsschicht vorgesehen sein, so dass die elektrische Kontakteinrichtung die eigentliche Elektrode nicht direkt kontaktiert. Mittels der erfindungsgemäßen Messvorrichtung lässt sich die Potentialverteilung und die Stromdichteverteilung auch bei nicht direktem Kontakt ermitteln. Ist die Schichtdicke der Gasdiffusionsschicht ausreichend gering, können Lateralströme (Ströme parallel zur Oberfläche der Gasdiffusionsschicht) vernachlässigt werden; weiterhin können Potentialänderungen über die Höhe der Gasdiffusionsschicht vernachlässigt werden. Die Potentialverteilung und Stromdichteverteilung an der Kontaktfläche der elektrischen Kontakteinrichtung stimmt dann näherungsweise mit der Potentialverteilung und Stromdichteverteilung an der Elektrodenfläche überein.

Sind Lateralströme in der Gasdiffusionsschicht und die Potentialänderung über der Höhe dieser Gasdiffusionsschicht nicht vernachlässigbar, lässt sich die Potentialverteilung an der Elektrodenfläche mittels der Potentialtheorie und durch Kalibriermessungen aus der bekannten Potentialverteilung und Stromdichteverteilung an der Kontaktfläche der elektrischen Kontakteinrichtung ermitteln.

Die elektrische Kontakteinrichtung ist bei der erfindungsgemäßen Messvorrichtung gegenüber einer Kontakteinrichtung ohne Messfunktion nur minimal modifiziert. Es lässt sich das gleiche Material verwenden. Es ist keine Segmentierung beispielsweise der Kontaktfläche notwendig. Die Strombelastung der Kontaktfläche wird nicht in einzelne Strompfade aufgeteilt. Weiterhin müssen keine zusätzlichen Messwiderstände vorgesehen werden. Auch das elektrische und thermische Strömungsfeld sowie die Geometrie und die Oberflächeneigenschaften (wie beispielsweise Hydrophobie/ Hydrophylie, Rauhigkeit) der elektrischen Kontakteinrichtung und insbesondere einer Kanalstruktur zur Strömungsführung von Reaktionsmedium entspricht weitestgehend einer elektrischen Kontakteinrichtung ohne elektrische Kontaktelemente.

Der Elektrode lässt sich über Kanäle in der Kontakteinrichtung Reaktionsmedium zuführen. Bei der erfindungsgemäßen Lösung lassen sich die erste Messfläche und die zweite Messfläche außerhalb einer Kanalstruktur anordnen. Dadurch müssen beispielsweise Kanalstrukturen für die Reaktionsmediumzufuhr (und Reaktionsmediumabfuhr) nicht modifiziert werden. Dadurch müssen auch Strömungseigenschaften für Reaktionsgase nicht modifiziert werden.

Ferner lässt sich die erfindungsgemäße Messvorrichtung auf einfache Weise herstellen. Es können Fertigungsverfahren für eine elektrische Kontakteinrichtung ohne Kontaktelemente übernommen werden.

Die Messvorrichtung kann benutzt werden, um die elektrische Potentialverteilung und daraus abgeleitet die Stromdichteverteilung beispielsweise an einer Gaselektrode oder an einer Brennstoffzellenelektrode zu ermitteln. Sie lässt sich im Gegensatz zu magneto-tomographischen Verfahren in Brennstoffzellensystemen integrieren.

Es ist beispielsweise möglich, auch Membranwiderstände mit Hilfe der Methode der elektrischen Impedanzspektroskopie lokal zu messen, indem das Potential in einem oder in mehreren Kontaktelementen der elektrischen Kontakteinrichtung von außen aufgeprägt und dabei zeitlich variiert wird.

Bei der erfindungsgemäßen Lösung wird die elektrische Kontakteinrichtung in ihrer Gesamtheit als dreidimensionaler Widerstand mit einem dreidimensionalen elektrischen Strömungsfeld betrachtet. Über die elektrische Potentialtheorie lässt sich die elektrische Potentialverteilung auf den Kontaktflächen ermitteln, die zu der ersten Messfläche und der zweiten Messfläche parallel sind, wenn die Potentialverteilung an den Messflächen bekannt ist. Alternativ wird die Potentialverteilung an der Kontaktfläche direkt gemessen. Die Stromdichteverteilung wird dann über Potentialtheorie aus der bekannten Potentialverteilung an der Oberfläche berechnet.

Grundsätzlich reicht es aus, wenn als Messflächen die erste Messfläche und die zweite Messfläche vorgesehen sind. Es können grundsätzlich aber auch noch weitere Messflächen vorgesehen sein.

Die erfindungsgemäße Messvorrichtung lässt sich im Zusammenhang mit planaren Elektrodensystemen einsetzen. Sie kann auch auf anderen Elektrodensysteme und insbesondere nicht planare Elektrodensysteme wie beispielsweise zylindrische oder kugelförmige Elektrodensysteme angewandt werden.

Ganz besonders vorteilhaft ist es, wenn die erste Messfläche und die zweite Messfläche parallel beabstandet sind. Dadurch lässt sich auf einfache Weise die elektrische Potentialverteilung an einer Kontaktfläche ermitteln.

Insbesondere ist es günstig, wenn die erste Messfläche eine Ebene ist. Dadurch kann auf einfache Weise mit Hilfe der Laplace-Gleichung unter Zugrundelegung der entsprechenden Randbedingungen aus der gemessenen Potentialverteilung in der ersten Messfläche und in der zweiten Messfläche die Potentialverteilung auf einer entsprechenden Kontaktfläche, über welche eine Elektrode die elektrische Kontakteinrichtung kontaktiert, berechnet werden.

Aus dem gleichen Grund ist es günstig, wenn die zweite Messfläche eine Ebene ist.

Es kann vorgesehen sein, dass die erste Messfläche und/oder die zweite Messfläche im Inneren der elektrischen Kontakteinrichtung liegt. Dadurch müssen die "makroskopischen" Eigenschaften der elektrischen Kontakteinrichtung nicht modifiziert werden. Insbesondere muss eine Kanalstruktur für die Reaktionsgaszufuhr und Reaktionsmediumabfuhr nicht modifiziert werden.

Günstig ist es dabei, wenn weder die erste Messfläche noch die zweite Messfläche die Kanalstruktur schneidet. Dadurch müssen Kanalstrukturen nicht modifiziert werden und die Verteilung der elektrischen Kontaktelemente auf der ersten Messfläche und der zweiten Messfläche kann unabhängig von der Kanalstruktur erfolgen.

Günstig ist es, wenn die elektrische Kontakteinrichtung einen oder mehrere Kanäle zur Zuführung von Reaktionsmedium zu der Elektrode und/oder zur Abführung von Reaktionsmedium von der Elektrode aufweist. Der oder die Kanäle sind dabei makroskopische Kanäle. Sie dienen zur Verteilung des Reaktionsmediums an die entsprechende Elektrode.

Insbesondere sind der oder die Kanäle zu der Elektrode oder einer Gasdiffusionsschicht hin offen, um eine gleichmäßige Beaufschlagung der Elektrodenfläche mit Reaktionsmedium zu erhalten. Es kann dabei vorgesehen sein, dass im Zwischenraum zwischen der elektrischen Kontakteinrichtung und der Elektrode dieser zugewandt eine Gasdiffusionsschicht vorliegt, über die Reaktionsmedium an die Elektrodenfläche auch unter den Stegen der Kanalstruktur fein diffundieren kann.

Vorteilhafterweise liegen die erste Messfläche und die zweite Messfläche außerhalb des Kanals oder außerhalb der Kanäle. Diese müssen dann durch die Anwesenheit der elektrischen Kontaktelemente nicht modifiziert werden und dadurch muss auch nicht die Strömungsführung für Reaktionsmedium modifiziert werden.

Aus dem gleichen Grund ist es günstig, wenn der oder die Kanäle zwischen einer der Elektrode zugewandten Kontaktfläche der elektrischen Kontakteinrichtung und der ersten Messfläche angeordnet sind bzw. zwischen einer der Elektrode zugewandten Kontaktfläche der elektrischen Kontakteinrichtung und der zweiten Messfläche angeordnet sind.

Bei einer Anwendung, bei der mehrere Elektroden in einem Elektrodensystem hintereinander geschaltet sind, wie beispielsweise einem Brennstoffzellenstapel, ist es günstig, wenn die elektrische Kontakteinrichtung als Bipolarplatte zur elektrischen Verbindung benachbarter Elektroden ausgebildet ist. Die Messvorrichtung außerhalb der Auswertungseinrichtung lässt sich dadurch in das Elektrodensystem auf einfache Weise integrieren. Die elektrische Kontakteinrichtung kann eine erste Kontaktfläche und eine zweite Kontaktfläche umfassen. Diese sind jeweils einer Elektrode zugewandt. Dies ist beispielsweise dann besonders vorteilhaft, wenn die elektrische Verbindung zwischen benachbarten Elektroden durch eine Bipolarplatte erfolgt und nicht mehrschichtig ausgeführt ist.

Insbesondere umfasst dann die elektrische Kontakteinrichtung einen ersten Kanal oder eine erste Gruppe von Kanälen für eine erste Elektrode und einen zweiten Kanal oder eine zweite Gruppe von Kanälen für eine zweite Elektrode. Über den ersten Kanal oder die erste Gruppe von Kanälen wird beispielsweise Brennstoff einer Anode zugeführt und über die zweiten Kanal oder die zweite Gruppe von Kanälen wird beispielsweise Oxidator einer Kathode zugeführt.

Insbesondere liegen dann die erste Messfläche und die zweite Messfläche zwischen dem oder den Kanälen für die erste Elektrode und dem oder den Kanälen für die zweite Elektrode innerhalb der elektrischen Kontakteinrichtung.

Es ist vorgesehen, dass zwischen der ersten Messfläche und der zweiten Messfläche Leitermaterial (für elektrische Leistung) angeordnet ist. Die elektrische Kontakteinrichtung läst sich dadurch auf einfache Weise herstellen. Durch das Leitermaterial ist eine elektrische Leitfähigkeit garantiert und es lässt sich auf einfache Weise eine Gasdichtigkeit der elektrischen Kontakteinrichtung realisieren. Grundsätzlich kann dabei für die Materialschicht zwischen der ersten Messfläche und der zweiten Messfläche das gleiche Material verwendet werden wie bei einer elektrischen Kontakteinrichtung ohne Messfunktion. Es lässt sich dann innerhalb der gesamten elektrischen Kontakteinrichtung eine homogene elektrische Leitfähigkeit erreichen. Die elektrische Kontakteinrichtung mit Messfunktion wird gegenüber einer elektrischen Kontakteinrichtung ohne Messfunktion nur minimal verändert. Es ist grundsätzlich auch möglich, dass die Materialschicht zwischen der ersten Messfläche und der zweiten Messfläche aus einem anderen Material wie der Rest der elektrischen Kontakteinrichtung hergestellt ist. Die elektrische Leitfähigkeit der Materialschicht zwischen der ersten Messfläche und der zweiten Messfläche und die Schichtdicke bestimmen den elektrischen Widerstand dieser Materialschicht. Beispielsweise ist für die Ermittlung der Potentialdifferenz zwischen der ersten Messfläche und der zweiten Messfläche bei gut elektrisch leitender Materialschicht mit geringer Dicke eine hohe Auflösung des Spannungssignals erforderlich. Es kann dann vorteilhaft sein, die elektrischen Eigenschaften der Materialschicht zwischen der ersten Messfläche und der zweiten Messfläche an die Messaufgabe anzupassen und die Materialschicht beispielsweise aus einem Leitermaterial mit geeigneter elektrischer Leitfähigkeit herzustellen.

Ganz besonders vorteilhaft ist es, wenn die erste Gruppe der elektrischen Kontaktelemente und/oder die zweite Gruppe der elektrischen Kontaktelemente an einem Träger angeordnet sind. Der Träger lässt sich als Ganzes positionieren. Dadurch ist die Herstellung vereinfacht. Auf dem Träger lassen sich die elektrischen Kontaktelemente entsprechend einem gewünschten (insbesondere zweidimensionalen) Gitter anordnen und insbesondere fixieren. Insbesondere lassen sich die Anzahl und Position der elektrischen Kontaktelemente auf dem jeweiligen Träger leicht der konkreten Aufgabenstellung der Messvorrichtung anpassen. So kann beispielsweise vorgesehen sein, die Potentialverteilung und Stromdichteverteilung an der Elektrode nur im Zuströmbereich und Abströmbereich einer Kanalstruktur zu ermitteln. In diesem Fall genügt es dann, die elektrischen Kontaktelemente nur in solchen Bereichen anzuordnen.

Ferner ist es günstig, wenn elektrische Leitungen an dem Träger angeordnet sind. Diese sind insbesondere als Leiterbahnen ausgebildet. Der Träger umfasst dadurch die elektrischen Kontaktelemente und die Leiterbahnen. Es ist dadurch beispielsweise möglich, die Kontaktelemente mit kleinen Abmessungen und auch die Leiterbahnen mit kleinen Abmessungen herzustellen.

Insbesondere ist es günstig, wenn der Träger eine flexible Leiterplatte ist. Solche flexiblen Leiterplatten lassen sich mit geringer Dicke (in der Größenordnung von 0,1 mm) herstellen. Sie lassen sich über dünne, hitzebeständige Folien realisieren, so dass beispielsweise auch bei der Herstellung eine Verpressung mit dem Material der elektrischen Kontakteinrichtung möglich ist. Die Leitungen lassen sich beispielsweise vollständig durch Lack oder durch eine dünne Foliendeckschicht elektrisch isolieren.

Ganz besonders vorteilhaft ist es, wenn die elektrischen Kontaktelemente Metallflächen aufweisen. Dadurch lässt sich das Potential im Bereich der Metallfläche ermitteln.

Insbesondere ist jeweils eine isolierte Leitung mit einer Metallfläche verbunden. Dadurch lässt sich für jedes elektrische Kontaktelement das Potential bestimmen.

Günstig ist es, wenn die elektrische Kontakteinrichtung (außerhalb der elektrischen Kontaktelemente und einem eventuellen Träger) aus einem Graphitmaterial hergestellt ist. Ein solches Graphitmaterial hat sich als vorteilhaft erwiesen für eine elektrische Kontakteinrichtung.

Günstig ist es, wenn die elektrischen Kontaktelemente an der ersten Messfläche und/oder der zweiten Messfläche regelmäßig angeordnet sind und beispielsweise ein zweidimensionales Gitter bilden. Es lässt sich dadurch aus den gemessenen Potentialdaten für räumlich diskrete Punkte eine kontinuierliche Potentialverteilung über bekannte mathematische Interpolationsverfahren wie beispielsweise interpolierende Oberflächensplines bestimmen.

Insbesondere ist durch die Auswertungseinrichtung und die Zugrundelegung der Laplace-Gleichung die Potentialverteilung und/oder Stromdichteverteilung an einer Kontaktfläche und damit an einer Elektrodenfläche berechenbar. Die Potentialverteilung an der Kontaktfläche kann dabei auch bei entsprechender Anordnung der Messflächen direkt gemessen werden oder berechnet werden. Falls die Potentialverteilung an einer Kontaktfläche nicht durch Messung ermittelt wird, wird auf den Potentialdaten der ersten Messfläche und der zweiten Messfläche die Potentialverteilung an der Kontaktfläche durch analytische und/oder nummerische Lösung der Laplace-Gleichung an der Kontaktfläche ermittelt. Aus der Potentialverteilung an der Kontaktfläche und der Potentialverteilung an einer Messfläche kann dann mit Hilfe der Potentialtheorie in einem weiteren Schritt die Stromdichteverteilung an der Kontaktfläche der elektrischen Kontakteinrichtung berechnet werden. Dadurch wiederum ist die Potentialverteilung an einer Elektrodenfläche ermittelbar.

Die Messvorrichtung lässt sich zusammen mit einer Elektrode zu einer Elektroden-Messvorrichtung-Kombination kombinieren.

Die erfindungsgemäße Messvorrichtung lässt sich im Zusammenhang mit einer Brennstoffzelle verwenden, wobei die Messvorrichtung an einer Kathode und/oder Anode angeordnet ist.

Insbesondere lässt sich mindestens eine erfindungsgemäße Messvorrichtung bei einem Brennstoffzellenstapel verwenden, welcher eine Mehrzahl von Brennstoffzellen umfasst, wobei zwischen Kathoden und Anoden benachbarter Brennstoffzellen eine Bipolarplatte angeordnet ist.

Es ist dann vorgesehen, dass die elektrische Kontakteinrichtung zwischen einer benachbarten Kathode und Anode angeordnet ist und insbesondere als Bipolarplatte ausgebildet ist.

Der Erfindung liegt ferner die Aufgabe zugrunde, ein Verfahren der eingangs genannten Art bereitzustellen, mit welchem sich auf einfache Weise die elektrische Potentialverteilung und/oder die Stromverteilung an einer Elektrode ermitteln lässt.

Diese Aufgabe wird bei dem eingangs genannten Verfahren erfindungsgemäß dadurch gelöst, dass die Elektrode mit einer elektrischen Kontakteinrichtung kontaktiert wird, die elektrische Potentialverteilung in einer ersten Messfläche und in einer zweiten Messfläche, welche zu der ersten Messfläche beabstandet ist, an der elektrischen Kontakteinrichtung gemessen wird, und mit Hilfe der elektrischen Potentialtheorie die elektrische Potentialverteilung und/oder Stromdichteverteilung auf einer Kontaktfläche der elektrischen Kontakteinrichtung, welche der Elektrode zugewandt ist, berechnet wird.

Das erfindungsgemäße Verfahren weist die bereits im Zusammenhang mit der erfindungsgemäßen Messvorrichtung erläuterten Vorteile auf.

Weitere vorteilhafte Ausführungsformen wurden ebenfalls bereits im Zusammenhang mit der erfindungsgemäßen Vorrichtung erläutert.

Es ist grundsätzlich möglich, die Potentialverteilung an einer Kontaktfläche direkt zu messen. Vorteilhaft ist es, wenn die erste Messfläche und/oder die zweite Messfläche im Inneren der elektrischen Kontakteinrichtung liegen. Dadurch muss die Oberfläche der elektrischen Kontakteinrichtung und ein Bereich unterhalb der Oberfläche nicht modifiziert werden. Dadurch wiederum lassen sich in diesem Bereich Kanäle einer Kanalstruktur zur Zuführung von Reaktionsmedium und Abführung von Reaktionsmedium/Reaktionsprodukten anordnen, ohne dass diese Anordnung Rücksicht nehmen muss auf die Kontaktelemente an der entsprechenden Messfläche.

Insbesondere wird die Potentialverteilung an der elektrischen Kontakteinrichtung stromlos gemessen. Durch stromlose Spannungsmessungen bezüglich eines Referenzpunktes werden die Potentiale ermittelt.

Die elektrische Potentialverteilung an einer Kontaktfläche der elektrischen Kontakteinrichtung wird (sofern sie nicht durch Messung bekannt ist) mit Hilfe der Laplace-Gleichung aus den Potentialverteilungen an der ersten Messfläche und der zweiten Messfläche berechnet. Die Laplace-Gleichung wird dabei analytisch und/oder nummerisch gelöst, wobei die Lösung die Stromdichteverteilung an der Kontaktfläche der Kontakteinrichtung angibt. In einer Auswertungseinrichtung sind die entsprechenden Berechnungsverfahren beispielsweise algorithmisch gespeichert.

Aus der Potentialverteilung kann die Stromdichteverteilung berechnet werden.

Unter Zugrundelegen des ermittelten Potentialverlaufs und/oder der ermittelten Stromdichteverteilung kann die Elektrode oder ein Elektrodensystem (wie beispielsweise ein Brennstoffzellenstapel) überwacht und/oder gesteuert und/oder geregelt werden. Dadurch lässt sich die Elektrode bzw. das Elektrodensystem optimiert betreiben.

Die nachfolgende Beschreibung bevorzugter Ausführungsformen dient im Zusammenhang mit der Zeichnung der näheren Erläuterung der Erfindung. Es zeigen:

Figur 1    eine schematische Darstellung eines Brennstoffzellenstapels mit einer Ausführungsform einer erfindungsgemäßen Messvorrich- tung;

Figur 2    eine schematische Schnittdarstellung eines Ausführungsbeispiels einer erfindungsgemäßen Messvorrichtung;

Figur 3    eine Schnittansicht längs der Linie 3-3 der Messvorrichtung gemäß Figur 2;

Figur 4    eine schematische Explosionsdarstellung der Messvorrichtung gemäß Figur 2 (Darstellung der einzelnen Bestandteile vor der Zusammensetzung); und

Figur 5    eine schematische Darstellung einer Messvorrichtung und der Flächen und Bereiche zur Berechnung der elektrischen Potential- verteilung.

Die erfindungsgemäße Messvorrichtung dient zur Ermittlung (Berechnung) der elektrischen Potentialverteilung an einer Elektrode. Aus der elektrischen Potentialverteilung kann die Stromdichteverteilung berechnet werden. Bei der Elektrode kann es sich beispielsweise um eine Gaselektrode oder eine Elektrode einer Brennstoffzelle handeln. Es ist auch möglich, mit einer (oder mehreren) Messvorrichtungen die elektrische Potentialverteilung an mehreren Elektroden zu ermitteln.

Im Folgenden wird ein Ausführungsbeispiel einer erfindungsgemäßen Messvorrichtung im Zusammenhang mit einem Brennstoffzellenstapel beschrieben.

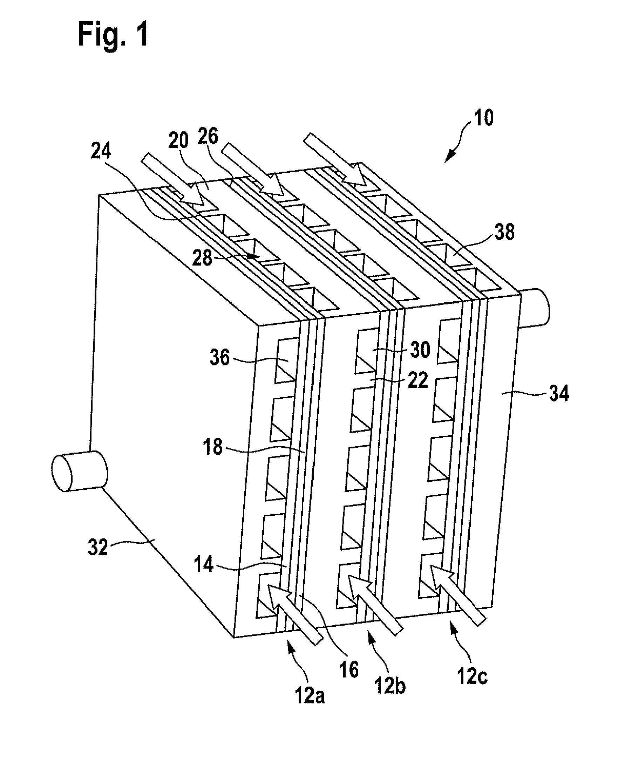

Ein Ausführungsbeispiel eines Brennstoffzellenstapels, welcher in Figur 1 schematisch gezeigt und dort mit 10 bezeichnet ist, umfasst eine Mehrzahl von Brennstoffzellen 12a, 12b, 12c (es können auch mehr oder weniger als drei Brennstoffzellen vorgesehen sein). Jede Brennstoffzelle 12a, 12b, 12c umfasst wiederum eine Kathode 14, eine Anode 16 und eine zwischen der Kathode 14 und der Anode 16 angeordnete Elektrolytschicht 18. Bei einer Niedertemperaturbrennstoffzelle ist die Elektrolytschicht beispielsweise eine Polymermembran; die entsprechende Brennstoffzelle ist dann eine PEMFC (Polymer Elektrolyte Membrane Fuel Cell).

Bei einer Hochtemperaturbrennstoffzelle wie bei einer SOFC (Solid Oxide Fuel Cell) ist die Elektrolytschicht 18 eine feste Elektrolytschicht beispielsweise aus einem oxidkeramischen Material.

Die Elektrolytschicht 18 ist gasundurchlässig. Sie ermöglicht je nach Typ der Brennstoffzelle 12a, 12b, 12c einen Protonentransport (bei der Niedertemperaturbrennstoffzelle) oder einen Sauerstoffionentransport (bei der Hochtemperaturbrennstoffzelle).

Der Kathode 14 wird Oxidator beispielsweise in Form von Luftsauerstoff zugeführt. Der Anode 16 wird Brennstoff beispielsweise in der Form von Wasserstoff zugeführt.

Bei dem gezeigten Ausführungsbeispiel weisen die Kathode 14 und die Anode 16 als Elektroden jeweils eine im Wesentlichen ebene Oberfläche auf. Die aus der Kathode 14, der Anode 16 und der dazwischen liegenden Elektrolytschicht 18 gebildete Elektroden-Elektrolyt-Einheit hat eine im Wesentlichen quaderförmige Gestalt.

Zwischen benachbarten Elektroden benachbarter Brennstoffzellen ist jeweils eine Bipolarplatte 20 angeordnet. Diese Bipolarplatte 20 umfasst eine elektrische Kontakteinrichtung 22 aus einem elektrisch leitfähigen Material. Beispielsweise ist die elektrische Kontakteinrichtung 22 aus Graphitmaterial hergestellt. Die elektrische Kontakteinrichtung 22 ist gasundurchlässig. Die elektrischen Kontakteinrichtungen 22 des Brennstoffzellenstapels 10 sorgen für eine elektrische Hintereinanderschaltung der Brennstoffzellen 12a, 12b, 12c.

Die elektrische Kontakteinrichtung 22 kontaktiert mit einer ersten Kontaktfläche 24 beispielsweise die Anode 16 der Brennstoffzelle 12a elektrisch. Mit einer gegenüberliegenden zweiten Kontaktfläche 26 kontaktiert die elektrische Kontakteinrichtung 22 die Kathode der benachbarten Brennstoffzelle 12b. Bei dem Kontakt handelt es sich dabei sowohl um einen mechanischen Kontakt als auch um einen elektrischen Kontakt, um den Stromfluss zu ermöglichen.

Die elektrische Kontakteinrichtung 22 kann mit der ersten Kontaktfläche 24 und der zweiten Kontaktfläche 26 direkt oder indirekt die entsprechende Elektrode elektrisch kontaktieren. Im ersten Fall bei der direkten Kontaktierung kontaktiert die elektrische Kontakteinrichtung 22 mit der entsprechenden Kontaktfläche 24 bzw. 26 die zugeordnete Elektrode auch mechanisch. In diesem Falle bildet die entsprechende Kontaktfläche auch eine Oberfläche der elektrischen Kontakteinrichtung 22, welche dann die Elektrode berührt.

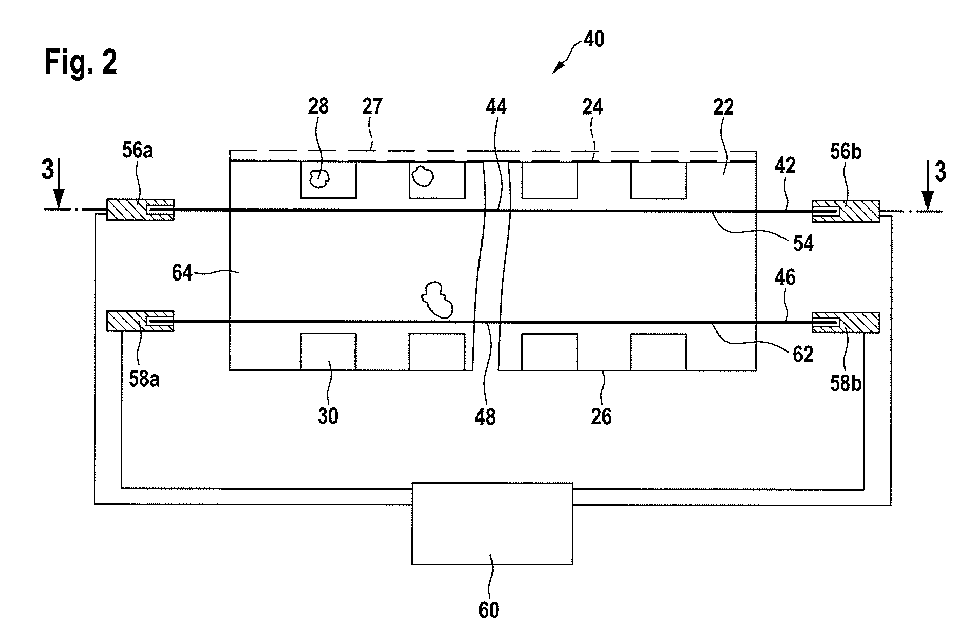

Es ist auch möglich, dass zwischen der entsprechenden Kontaktfläche 24 bzw. 26 und der zugeordneten Elektrode eine Gasdiffusionsschicht angeordnet ist. Eine solche Gasdiffusionsschicht ist in Figur 2 durch das Bezugszeichen 27 angedeutet. Die Gasdiffusionsschicht dient zur gleichmäßigen Verteilung von Reaktionsmedium auf die Elektrode und bedeckt vorzugsweise die entsprechende Elektrode.

Die Gasdiffusionsschicht 27 kann dabei an der elektrischen Kontakteinrichtung 22 angeordnet sein oder an der entsprechenden Elektrode angeordnet sein.

Die elektrische Kontakteinrichtung 22 weist eine erste Gruppe von Kanälen 28 auf. Es ist dabei grundsätzlich möglich, dass auch nur ein einziger Kanal vorhanden ist, der entsprechend ausgebildet ist. Über den Kanal bzw. die erste Gruppe an Kanälen 28 ist der Anode 16 der Brennstoffzelle 12a Brennstoff zuführbar und es ist Reaktionsmedium abführbar. Die Kanäle 28 sind makroskopisch ausgebildet. Sie sind zu der Anode 16 bzw. zu der Gasdiffusionsschicht 27 hin offen. Über die Kanäle 28 wird Brennstoff zugeführt mit dem Ziel, die Oberfläche der Anode 16 möglichst gleichmäßig mit Reaktionsmedium zu beaufschlagen.

Im Bereich zwischen den Kanälen 28 und insbesondere zu der Oberfläche der Elektrode 16 kann die Gasdiffusionsschicht 27 vorhanden ist.

Weiterhin weist die elektrische Kontakteinrichtung 22 eine zweite Gruppe 30 von Kanälen auf, welche der Kathode der benachbarten Brennstoffzelle 12b zugewandt offen sind. Über diese Kanäle 30 wird dieser Kathode 14 Oxidator zugeführt. Die Kanäle 30 sind makroskopische Kanäle. Auch hier kann eine Gasdiffusionsschicht vorgesehen sein.

Es ist grundsätzlich möglich, dass auch nur ein einziger entsprechend geführter Kanal vorhanden ist.

Die Kanäle 28 und die Kanäle 30 sind gasdicht voneinander getrennt.

An seinen Außenseiten weist der Brennstoffzellenstapel 10 jeweils äußere Kontaktplatten 32, 34 auf. Diese weisen jeweils Kanäle 36, 38 auf, um den am weitesten außen liegenden Elektroden (im gezeigten Beispiel der Kathode 14 der Brennstoffzelle 12a und der Anode der Brennstoffzelle 12c) Oxidator bzw. Brennstoff zuführen zu können. Ferner ist der von dem Brennstoffzellenstapel 10 erzeugte Strom über die äußeren Kontaktplatten 32, 34 abgreifbar.

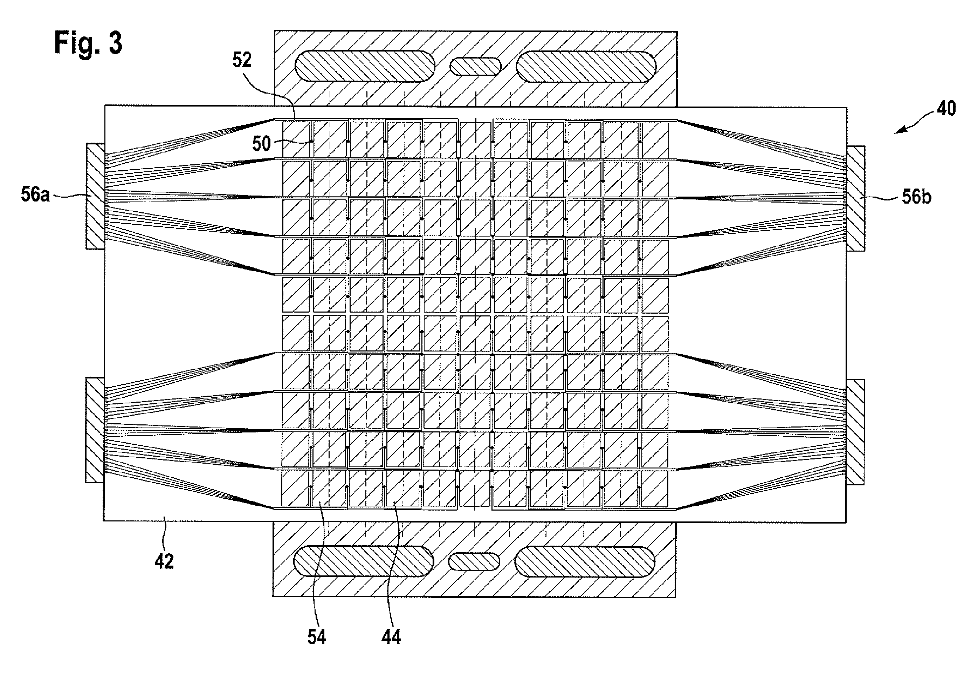

Bei einem Ausführungsbeispiel einer erfindungsgemäßen Messvorrichtung, welches in den Figuren 2 und 3 schematisch gezeigt ist, und dort mit 40 bezeichnet ist, ist eine elektrische Kontakteinrichtung 22 vorgesehen, welche mit Messelementen zur Potentialmessung versehen ist. Diese Messelemente sind dabei im Inneren der elektrischen Kontakteinrichtung 22 beabstandet zu der ersten Kontaktfläche 24 und der zweiten Kontaktfläche 26 angeordnet.

Bei einem Ausführungsbeispiel ist dabei die elektrische Kontakteinrichtung 22 so ausgebildet, dass die erste Kontaktfläche 24 und die zweite Kontaktfläche 26 im Wesentlichen parallel zueinander ausgerichtet sind. Insbesondere sind die erste Oberfläche 24 und die zweite Oberfläche 26 eben.

Die Messvorrichtung 40 umfasst einen ersten Träger 42, welcher einen Bereich 44 aufweist, der innerhalb der elektrischen Kontakteinrichtung 22 außerhalb der Kanäle 28 angeordnet ist. Ferner umfasst die Messvorrichtung 40 einen zweiten Träger 46, welcher mit einem Bereich 48 innerhalb der elektrischen Kontakteinrichtung 22 beabstandet zu der zweiten Oberfläche 26 außerhalb der Kanäle 30 und beabstandet zu dem ersten Träger 42 innerhalb der elektrischen Kontakteinrichtung 22 angeordnet ist.

Der erste Träger 42 und der zweite Träger 46 sind Träger für elektrische Kontaktelemente 50 (Figur 3), welche zur Potentialmessung innerhalb der elektrischen Kontakteinrichtung 22 dienen. Die elektrischen Kontaktelemente 50 sind beispielsweise durch Metallflächen auf dem jeweiligen Träger 42, 46 gebildet. Zu den jeweiligen elektrischen Kontaktelementen 50 führen isolierte Leitungen 52. Die isolierten Leitungen 52 sind dabei wiederum auf dem jeweiligen Träger 42 bzw. 46 angeordnet.

Die elektrischen Kontaktelemente sind an dem ersten Träger 42 auf einer ersten Messfläche 54 angeordnet. Sie sind gleichmäßig über die Messfläche 54 verteilt, um die Potentialverteilung auf der Fläche gleichmäßig erfassen zu können.

Die Messfläche 54 ist insbesondere eine Ebene. Die elektrischen Kontaktelemente 50 der Messfläche 54 sind dann in einem zweidimensionalen Gitter angeordnet.

Die elektrischen Leitungen 52 jeweils an dem ersten Träger 42 und an dem zweiten Träger 46 sind an Steckverbinder 56a, 56b, 58a, 58b angeschlossen. Durch diese Steckverbinder 56a, 56b, 58a, 58b ist ein Zugriff auf die bereitgestellten Messsignale von außen möglich.

Insbesondere ist eine Auswertungseinrichtung 60 über die Steckverbinder 56a, 56b, 58a, 58b angeschlossen. Über die Auswertungseinrichtung 60 können aus den Messsignalen (Potentialdaten an der Messfläche 54) Potentialdaten für die Oberfläche der zugeordneten Elektrode berechnet werden. Weiterhin können dann aus diesen letzten Potentialdaten wieder Stromdichteverteilungsdaten berechnet werden.

Durch den zweiten Träger 46 ist eine zweite Messfläche 62 definiert. Auf der zweiten Messfläche 62 sind die entsprechenden elektrischen Kontaktelemente 50 des zweiten Trägers 46 angeordnet.

Die zweite Messfläche 62 ist dabei vorzugsweise parallel beabstandet zu der ersten Messfläche 54. Insbesondere ist die zweite Messfläche 62 eine Ebene. Die elektrischen Kontaktelemente 50 sind auf der zweiten Messfläche 62 verteilt und insbesondere regelmäßig angeordnet. Beispielsweise sind sie in einem zweidimensionalen Gitter angeordnet.

Die elektrischen Kontaktelemente an dem ersten Träger 42 und dem zweiten Träger 46 sind dann in einem dreidimensionalen Gitter angeordnet, welches als Hüllenflächen die erste Messfläche 54 und die zweite Messfläche 62 aufweist.

Die erste Messfläche 54 und die zweite Messfläche 62 sind vorzugsweise im Wesentlichen parallel zu der entsprechenden Elektrode, deren Potentialverteilung bestimmt werden soll.

Bei einem Ausführungsbeispiel sind die Träger 42 und 46 flexible Leiterplatten, welche beispielsweise aus Polyimid hergestellt sind. Diese umfassen beispielsweise Kupferflächen als elektrische Kontaktelemente 50. Die elektrischen Kontaktelemente 50 können dabei aufgeklebt sein oder direkt aufgebracht sein. In die entsprechende flexible Leiterplatte sind die Leitungen 52 als Leiterbahnen integriert.

Eine typische Dicke einer solchen flexiblen Leiterplatte liegt in der Größenordnung zwischen ca. 100 $\mu$m und 250 $\mu$m. (Wenn die elektrischen Kontaktelemente aufgeklebt sind, dann ist die Dicke üblicherweise größer.)

Zwischen dem ersten Träger 42 und dem zweiten Träger 46 ist eine Materialschicht 64 aus Leitermaterial und insbesondere Vollmaterialschicht angeordnet. Oberhalb des ersten Trägers 42 sitzt eine Schicht 66 (aus Vollmaterial), an welcher die Kanäle 28 gebildet sind. Unterhalb des zweiten Trägers 46 sitzt eine Schicht 68, an welcher die Kanäle 30 gebildet sind. Die Materialschicht 64 ist vorzugsweise aus dem gleichen Material wie die Schicht 66 und die Schicht 68 hergestellt.

Die Kanäle 28 sitzen zwischen der Elektrode, welche die erste Oberfläche 24 der elektrischen Kontakteinrichtung 22 kontaktiert, und dem ersten Träger 42. Die Kanäle 30 sind zwischen dem zweiten Träger 46 und der zweiten Oberfläche 26 angeordnet.

Bei der Herstellung der elektrischen Kontakteinrichtung 22 werden beispielsweise beim Heißpressen oder Gießen eines Graphitmaterials die Träger 42 und 46 mit definiertem Abstand und in definierter Lage in die Pressform oder Gießform eingebracht bzw. dort angeordnet. In die Pressform oder Gießform können dabei Kanal-Negativstrukturen eingeprägt sein.

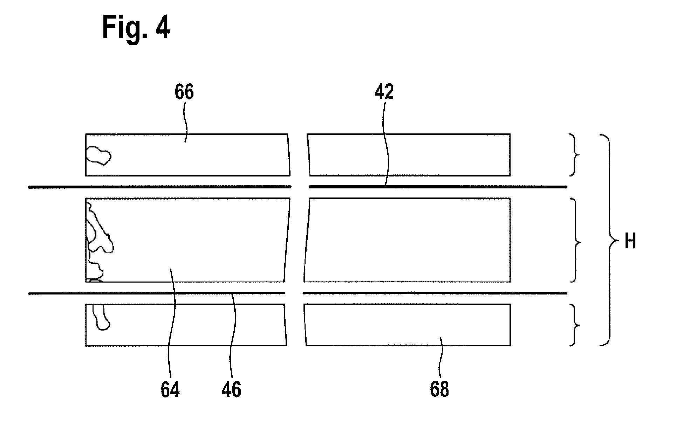

Bei einem Ausführungsbeispiel weist die elektrische Kontakteinrichtung 22 eine Höhe H auf (Figur 4), welche in der Größenordnung von 3 mm liegt. Beispielsweise weist die Schicht 66 eine Höhe von 0,7 mm auf, die Vollmaterialschicht 64 eine Höhe von 1,4 mm und die Schicht 68 eine Höhe von 0,7 mm. Eine typische Höhe jeweils für den ersten Träger 42 und den zweiten Träger 46 liegt bei jeweils 0,1 mm.

Es ist grundsätzlich möglich, dass über eine erfindungsgemäße Messvorrichtung die Potentialverteilung an einer Elektrode ermittelt wird oder an zwei Elektroden. Im letzteren Fall ist dann insbesondere die entsprechende elektrische Kontakteinrichtung 22 als Bipolarplatte ausgebildet.

Auch die Kontaktplatte 32, 34 können als Messvorrichtung 40 ausgebildet sein.

Ferner ist es möglich, dass in dem Brennstoffzellenstapel 10 eine elektrische Kontakteinrichtung mit elektrischen Kontaktelementen 50 versehen ist, mehrere elektrische Kontakteinrichtungen mit elektrischen Kontaktelementen versehen sind oder alle elektrischen Kontakteinrichtungen mit elektrischen Kontaktelementen versehen sind. Wie eben erwähnt, können auch die Kontaktplatten 32, 34 mit elektrischen Kontaktelementen versehen sein.

Weiterhin ist es möglich, dass eine Auswertungseinrichtung 60 einer Mehrzahl von elektrischen Kontakteinrichtungen 22 zugeordnet ist, oder dass eine individuelle Auswertungseinrichtung 60 jeder elektrischen Kontakteinrichtung 22, welche mit elektrischen Kontaktelementen 50 versehen ist, zugeordnet ist.

Das erfindungsgemäße Verfahren funktioniert wie folgt:

In der ersten Messfläche 54 und der zweiten Messfläche 62 wird über die dortigen elektrischen Kontaktelemente 50 jeweils die elektrische Potentialverteilung gemessen. Diese Messflächen 54, 62 liegen dabei innerhalb der elektrischen Kontakteinrichtung 22 jeweils beabstandet zu der ersten Oberfläche 24 und der zweiten Oberfläche 26 und insbesondere außerhalb der Kanäle 28 und 30.

Die elektrische Kontakteinrichtung 22 wird in ihrer Gesamtheit als dreidimensionaler Widerstand mit dreidimensionalem elektrischem Strömungsfeld aufgefasst. Die elektrische Potentialverteilung auf der ersten Oberfläche 24 und der zweiten Oberfläche 26 der elektrischen Kontakteinrichtung 22 kann mittels der elektrischen Potentialtheorie aus den gemessenen Potentialdaten an der ersten Messfläche 54 und der zweiten Messfläche 62 berechnet werden. Wenn man Lateralströme in jeweiligen Gasdiffusionsschichten der entsprechenden Brennstoffzelle 12a usw. vernachlässigt, dann entspricht die Potentialverteilung an der ersten Oberfläche 24 der Potentialverteilung auf der Elektrode, welche durch die erste Oberfläche 24 kontaktiert wird. Ferner entspricht die Potentialverteilung an der zweiten Oberfläche 26 der Potentialverteilung an der Elektrode, welche durch diese zweite Oberfläche 26 kontaktiert wird.

Wenn zwischen Anoden- und Kathodenkammern eines mehrzelligen Elektrodensystems (wie beispielsweise des Brennstoffzellenstapels 10) einschichtige Bipolarplatten mit zwei Kontaktflächen 24, 26 angeordnet sind, so entsprechen die Potentialverteilungen an diesen Kontaktflächen 24, 26 den Potentialverteilungen an den Elektrodenflächen, die den Kontaktflächen 24, 26 jeweils gegenüberliegen. In diesem Fall reicht dann in einem Brennstoffzellenstapel 10 die Messung der Potentialverteilung an jeder zweiten Bipolarplatte 20 aus, um beispielsweise die Stromdichteverteilung auf allen Elektrodenflächen des Brennstoffzellenstapels 10 zu bestimmen. Bei mehrschichtigen Bipolarplatten sind zusätzliche Messflächen in der Messvorrichtung erforderlich.

Die elektrischen Kontaktelemente an der ersten Messfläche 54 und der zweiten Messfläche 62 stellen Messkontakte bereit, wobei die Messkontakte auf unterschiedlichen Flächen (und insbesondere Ebenen) angeordnet sind. Durch die isolierten Leitungen 52 werden die Messsignale (Spannungssignale) nach außen geführt. Über ein Spannungsmessgerät, welches beispielsweise in die Auswertungseinrichtung 60 integriert ist oder auch außerhalb der Auswertungseinrichtung 60 angeordnet sein kann, werden die Potentialdaten ermittelt.

Unter Kenntnis der Lage der ersten Messfläche 54 und der zweiten Messfläche 62, der relativen Lage der elektrischen Kontaktelemente 50 auf den Flächen 54, 62 (Messebenen) und der elektrischen Leitfähigkeit des Materials der elektrischen Kontakteinrichtung 22 (außerhalb der Träger 42, 46) kann mit Hilfe der elektrischen Potentialtheorie unter Zugrundelegung der Laplace-Gleichung die elektrische Potentialverteilung auf der ersten Kontaktfläche 24 und der zweiten Kontaktfläche 26 berechnet werden.

In Leitern mit kontinuierlicher räumlicher Erstreckung stellt die eindimensionale Behandlung der elektrischen Strömung in der Regel nur eine grobe Näherung dar, da sich in der Regel die Potentialverteilung in allen drei Raumrichtungen des räumlich ausgedehnten Leiters ändert. Aus der Messung der Potentialdifferenzen zwischen den elektrischen Kontaktelementen 50, die sich auf der ersten Messfläche 54 und der zweiten Messfläche 62 jeweils gegenüberliegen, kann im allgemeinen nur in einer ersten Näherung auf die Verteilung des Vertikalstroms (des elektrischen Stroms in Richtung der Flächennormalen der elektrischen Kontakteinrichtung 22) an den Kontaktflächen geschlossen werden. Die Messung der Potentialdifferenzen zwischen Messflächen 54, 62 liefert nämlich die Vertikalstromdichte an den Kontaktflächen nur dann korrekt, wenn die Potentialverteilung auf den Messflächen 54, 62 jeweils homogen ist und damit in der elektrischen Kontakteinrichtung 22 keine Lateralströme (Ströme senkrecht zur Flächennormalen der elektrischen Kontakteinrichtung 22) auftreten. Durch die Anwendung der Potentialtheorie lässt der Einfluss eines Lateralstroms auf die Ermittlung der Stromdichteverteilung an den Kontaktflächen erfassen bzw. korrigieren.

Die Laplace-Gleichung kann analytisch oder numerisch gelöst werden.

Durch die Verwendung von flexiblen Leiterplatten für den ersten Träger 42 und den zweiten Träger 46, welche durch dünne und hitzebeständige Folien realisiert sind, lassen sich die elektrischen Kontaktelemente 50 rasterartig positionieren. Die elektrischen Kontaktelemente 50 und die zugehörigen Leitungen 52 lassen sich mit kleinen geometrischen Abmessungen ausbilden. Die Leitungen 52 können beispielsweise durch einen Lack oder durch eine dünne Foliendeckschicht elektrisch isoliert sein.

Der Zwischenbereich 64 zwischen dem ersten Träger 42 und dem zweiten Träger 46 lässt sich mit einem geeigneten Leitermaterial füllen.

Durch den ersten Träger 42 und den zweiten Träger 46 ist die räumliche Lage der elektrischen Kontaktelemente 50 festgelegt und die erste Messfläche 54 und die zweite Messfläche 62 sind als Messebenen festgelegt.

Der erste Träger 42 und der zweite Träger 46 lässt sich außerhalb der entsprechenden Messfläche dazu nutzen, die Leitungen 52 (in der Form von Leiterbahnen) zu den jeweiligen Steckverbindern 56a, 56b, 58a, 58b zu führen.

Durch das Gitter der elektrischen Kontaktelemente 50 mit relativ schmalen Stegen wird das elektrische Strömungsfeld und Potentialfeld im Vergleich zu einer elektrischen Kontakteinrichtung 22, welche nicht als Messvorrichtung 40 ausgebildet ist, nur geringfügig verändert.

Durch die Anordnung der ersten Messfläche 54 und der zweiten Messfläche 62 als Messflächen innerhalb der elektrischen Kontakteinrichtung 22 muss die Kanalstruktur zur Zuführung von Reaktionsmedium zu einer Elektrode nicht modifiziert werden.

Für die elektrische Kontakteinrichtung 22 lässt sich das gleiche Material verwenden wie für eine herkömmliche Bipolarplatte. Es müssen keine zusätzlichen Messwiderstände eingebracht werden. Das thermische und elektrische Strömungsfeld entspricht dadurch dem thermischen bzw. elektrischen Strömungsfeld einer "unmodifizierten" Platte. Wie erwähnt, tritt keine Veränderung der Strömungseigenschaften von Reaktionsmedium in den Kanälen 28, 30 auf, da diese Kanäle nicht modifiziert werden müssen. Außerdem ändern sich dann die thermischen Eigenschaften der elektrischen Kontakteinrichtung 22 im Vergleich zu einer unmodifizierten elektrischen Kontakteinrichtung nicht wesentlich.

Die elektrische Kontakteinrichtung 22 und dadurch auch die Messvorrichtung 40 lässt sich auf einfache und kostengünstige Weise herstellen, wobei eine Anpassung an spezielle Verhältnisse auf einfache Weise möglich ist. Beispielsweise werden die grundsätzlichen Fertigungsverfahren für eine Bipolarplatte übernommen, wobei die Gitterschichten über den ersten Träger 42 und den zweiten Träger 46 eingefügt werden.

Die Messvorrichtung 40 lässt sich auf einfache Weise beispielsweise an einen Brennstoffzellenstapel 10 integrieren.

Auch die Anwendung zur Messung der Potentialverteilung an einer anderen Elektrodenart, wie beispielsweise einer Gaselektrode ist möglich.

Die gewonnenen Daten können beispielsweise zur Überwachung des Brennstoffzellenstapels 10 und/oder zu dessen Steuerung und/oder zu dessen Regelung eingesetzt werden.

Die Auswertungseinrichtung 60 berechnet aus den gemessenen Potentialdaten die elektrische Potentialverteilung an der ersten Oberfläche 24 und/oder der zweiten Oberfläche 26. Zugrunde gelegt wird die Laplace-Gleichung:

$$\Delta\varphi = 0$$

$\varphi$ ist dabei das elektrische Potential.

Die Laplace-Gleichung gilt in Bereichen mit der Gesamtladungsdichte $p = 0$

Als Ergebnis der Messungen in der Messfläche 54 und der Messfläche 62 erhält man die Potentialverteilung dort als $\varphi_1$ ($x,y,z1$) und $\varphi_2$ ($x,y,z2$);

x, y, z sind dabei die Ortskoordinaten; die erste Messfläche 54 sitzt bei z2 und die zweite Messfläche 62 sitzt bei z1.

Die Funktionen $\varphi_1$ ($x,y,z1$) und $\varphi_2$ (x, y,z2) werden aus den ermittelten Potentialwerten an den diskreten Messpunkten beispielsweise mit interpolierenden Oberflächensplines konstruiert.

Die Laplace-Gleichung wird dann beispielsweise analytisch (beispielsweise über die Methode der Variablentrennung) oder numerisch (beispielsweise über finite Differenzenmethoden) gelöst. Es sind dabei Randbedingungen bekannt. Auf der ersten Messfläche 54 ist die Potentialverteilung bekannt. Ferner ist sie durch die Messwerte auf der zweiten Messfläche 62 bekannt. Es liegen dadurch Dirichlet'sche Randbedingungen vor. An den Seitenflächen dazu erfolgt kein Stromfluss. Es liegen hier Neumann'sche Randbedingungen vor.

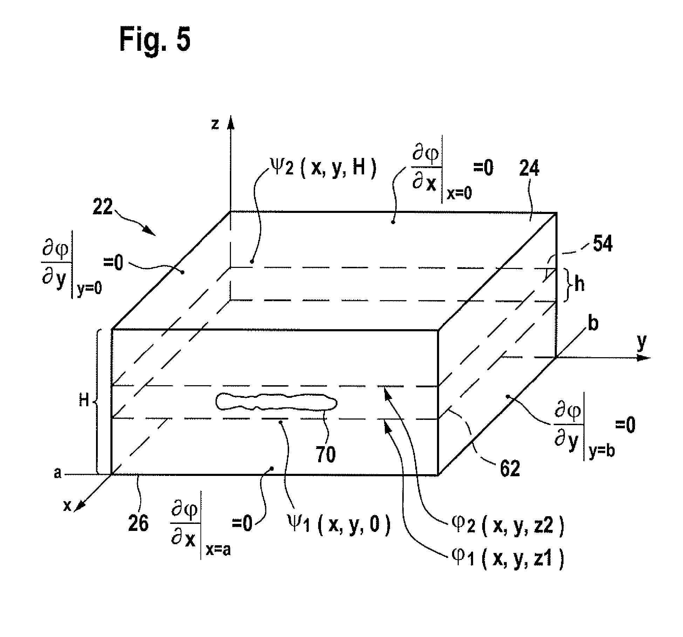

Dies ist in Figur 5 durch die entsprechenden Potentialgradientenfunktionen angedeutet.

Innerhalb eines "Kontrollbereichs" 70 zwischen der ersten Messfläche 54 und der zweiten Messfläche 62 lässt sich bei quaderförmiger Gestalt die Potentialverteilung als analytische Lösung der Laplace-Gleichung wie folgt angeben:

$$\varphi(x,y,z) = a_0 + (b_0 - a_0)\cdot z +$$

$$\sum_{n=1}^{\infty}\sum_{m=1}^{\infty}\left(A_{nm}\sinh[r_{nm}\pi\cdot(\mathrm{h}-z)] + B_{nm}\sinh[r_{nm}\pi\cdot z]\right)\cdot\cos(\frac{n\pi}{a}x)\cos(\frac{m\pi}{b}y),$$

wobei

$$r_{nm} = \left(\frac{n^2}{a^2} + \frac{m^2}{b^2}\right)^{1/2}$$

a und b sind dabei die jeweiligen Seitenbreiten.

Für z = 0 ergibt sich dadurch

$$\varphi_1(x,y,0) = a_0 + \sum_{n=1}^{\infty}\sum_{m=1}^{\infty}\left(A_{nm}\sinh[r_{nm}\pi\cdot\mathrm{h}]]\right)\cdot\cos(\frac{n\pi}{a}x)\cos(\frac{m\pi}{b}y)$$

und für z = h ergibt sich

$$\phi_2(x,y,h) = a_0 + (b_0 - a_0)\cdot h + \sum_{n=1}^{\infty}\sum_{m=1}^{\infty}\left(B_{nm}\sinh[r_{nm}\pi\cdot h]]\right)\cdot\cos(\frac{n\pi}{a}x)\cos(\frac{m\pi}{b}y)$$

Die jeweils genannten Gleichungen sind Fourierreihen-Darstellungen der ermittelten Funktionen $\phi_1$ und $\phi_2$. Aus diesen Fourierreihen-Darstellungen können dann die per se unbekannten Fourierkoeffizienten bestimmt werden können.

Die Stromdichteverteilungen an der ersten Messfläche 54 und der zweiten Messfläche 62 können wie folgt ermittelt werden:

Für die Vertikalstromdichten gilt

$$J_{1z} = -\sigma_z \cdot \frac{\partial\phi_1}{\partial z}$$

bzw.

$$J_{2z} = -\sigma_z \cdot \frac{\partial\phi_2}{\partial z}$$

und für die Lateralstromdichten gilt

$$J_{1x} = -\sigma_x \cdot \frac{\partial\phi_1}{\partial x}, \quad J_{1y} = -\sigma_y \cdot \frac{\partial\phi_1}{\partial y} \text{ bzw. } J_{2x} = -\sigma_x \cdot \frac{\partial\phi_2}{\partial x}, \quad J_{2y} = -\sigma_y \cdot \frac{\partial\phi_2}{\partial y}$$

Eine Anistoropie der elektrischen Leitfähigkeit kann mathematisch durch Dehnung oder Stauchung des Kontrollbereichs 70 in der x-Richtung und/oder y-Richtung berücksichtigt werden.

Die Potentialverteilungen $\psi_1(x,y,0)$ auf der zweiten Oberfläche 26 und $\psi_2(x,y,H)$ auf der ersten Oberfläche 24 kann beispielsweise iterativ ermittelt werden, indem die Iteration derart erfolgt, dass die ermittelten Stromdichteverteilungen und Potentialverteilungen in der ersten Messfläche 54 und der zweiten Messfläche 62 eingehalten werden.

Daraus kann dann weiter die Ermittlung der Stromdichteverteilung an der ersten Kontaktfläche 24 und an der zweiten Kontaktfläche 26 der elektrischen Kontakteinrichtung 22 erfolgen, wodurch schließlich die Stromdichteverteilung an Elektrodenfläche bestimmbar ist.

Zwischen der Kontaktfläche der elektrischen Kontakteinrichtung 22 und der eigentlichen Elektrodenfläche kann eine Gasdiffusionsschicht angeordnet sein. Die Gasdiffusionsschicht kann dabei an der elektrischen Kontakteinrichtung oder auf der Elektrodenfläche positioniert sein. In diesem Falle kontaktiert die elektrische Kontakteinrichtung die Elektrode nicht direkt, sondern mittels der Gasdiffusionsschicht. Durch die erfindungsgemäße Lösung lässt sich die Potentialverteilung und die Stromdichteverteilung auch bei einem solchen nicht direkten Kontakt ermitteln. Wenn die Schichtdicke der Gasdiffusionsschicht (Schicht 27 in Figur 2) ausreichend gering ist, können Lateralströme (Ströme parallel zur Oberfläche der Gasdiffusionsschicht 27) vernachlässigt werden. Weiterhin können Potentialänderungen über die Höhe der Gasdiffusionsschicht 27 vernachlässigt werden. Die Potentialverteilung und Stromdichteverteilung an der Kontaktfläche 24, 26 der elektrischen Kontakteinrichtung 22 stimmt dann näherungsweise mit der Potentialverteilung und Stromdichteverteilung an der Elektrodenfläche überein.

Im Falle, dass Lateralströme in der Gasdiffusionsschicht 27 und die Potentialänderung über die Höhe dieser Gasdiffusionsschicht 27 nicht vernachlässigbar ist, lässt sich die Potentialverteilung an der Elektrodenfläche mittels der Potentialtheorie und durch Kalibriermessung aus der bekannten Potentialverteilung und Stromdichteverteilung an der Kontaktfläche 24, 26 der elektrischen Kontakteinrichtung 22 ermitteln.

Durch die erfindungsgemäße Lösung ist es auch möglich, beispielsweise Membranwiderstände in einer PEMFC impedanzspektroskopisch lokal zu messen. Dabei wird einem oder mehreren elektrischen Kontaktelementen 50 der elektrischen Kontakteinrichtung 22 extern ein Potential aufgeprägt, welches zeitlich variiert wird. Durch Impedanzmessung lässt sich entsprechend der Membranwiderstand bestimmen.

**Patentansprüche**

1. Messvorrichtung zur Ermittlung des elektrischen Potentials und/oder der Stromdichte an einer Elektrode (14; 16), umfassend eine elektrische Kontakteinrichtung (22), welche die Elektrode (14; 16) kontaktiert, eine erste Gruppe von elektrischen Kontaktelementen (50) aufweist, die in einer ersten Messfläche (54) verteilt angeordnet sind und über welche die elektrische Potentialverteilung an der ersten Messfläche (54) messbar ist, mindestens eine zweite Gruppe an elektrischen Kontaktelementen (50) aufweist, welche in einer zweiten Messfläche (62) verteilt angeordnet sind und über die die elektrische Potentialverteilung an der zweiten Messfläche (62) messbar ist, wobei die erste Messfläche (54) und die zweite Messfläche (62) beabstandet zueinander sind, und eine Auswertungseinrichtung (60), mit der auf Grundlage der elektrischen Potentialtheorie aus den gemessenen Potentialen die elektrische Potentialverteilung und/oder Stromdichteverteilung an der Elektrode (14; 16) bestimmbar ist.

2. Messvorrichtung nach Anspruch 1, **dadurch gekennzeichnet, dass** die erste Messfläche (54) und die zweite Messfläche (62) parallel beabstandet sind.

3. Messvorrichtung nach einem der vorangehenden Ansprüche, **dadurch gekennzeichnet, dass** die erste Messfläche (54) und/oder die zweite Messfläche (62) im Inneren der elektrischen Kontakteinrichtung (22) liegen.

4. Messvorrichtung nach einem der vorangehenden Ansprüche, **dadurch gekennzeichnet, dass** die elektrische Kontakteinrichtung (22) einen oder mehrere Kanäle (28; 30) zur Zuführung von Reaktionsmedium zu der Elektrode (14; 16) und/oder zur Abführung von Reaktionsmedium von der Elektrode (14; 16) aufweist.

5. Messvorrichtung nach einem der vorangehenden Ansprüche, **dadurch gekennzeichnet, dass** die elektrische Kontakteinrichtung (22) als Bipolarplatte (20) zur elektrischen Verbindung benachbarter Elektroden (14; 16) ausgebildet ist.

6. Messvorrichtung nach einem der vorangehenden Ansprüche, **dadurch gekennzeichnet, dass** zwischen der ersten Messfläche (54) und der zweiten Messfläche (62) Leitermaterial (64) angeordnet ist.

7. Messvorrichtung nach einem der vorangehenden Ansprüche, **dadurch gekennzeichnet, dass** die erste Gruppe der elektrischen Kontaktelemente (50) und/oder die zweite Gruppe der elektrischen Kontaktelemente (50) an einem Träger (42; 46) angeordnet sind, wobei insbesondere elektrische Leitungen (52) an dem Träger (42; 46) angeordnet sind.

8. Messvorrichtung nach einem der vorangehenden Ansprüche, **dadurch gekennzeichnet, dass** die elektrischen Kontaktelemente (50) Metallflächen aufweisen, wobei insbesondere eine isolierte Leitung (52) mit einer Metallfläche verbunden ist.

9. Messvorrichtung nach einem der vorangehenden Ansprüche, **dadurch gekennzeichnet, dass** durch die Auswertungseinrichtung (60) unter Zugrundelegung der Laplace-Gleichung aus dem gemessenen Potential im Inneren der elektrischen Kontakteinrichtung (22) die Potentialverteilung an einer der Elektrode (14; 16) zugewandten Oberfläche (24; 26) der elektrischen Kontakteinrichtung (22) berechenbar ist.

10. Elektroden-Messvorrichtung-Kombination, umfassend mindestens eine Elektrode und mindestens eine Messvorrichtung gemäß einem der vorangehenden Ansprüche.

11. Brennstoffzelle, umfassend eine Messvorrichtung gemäß einem der vorangehenden Ansprüche, welche an einer Kathode (14) und/oder Anode (16) angeordnet ist, und Brennstoffzellenstapel, umfassend eine Mehrzahl von Brennstoffzellen, wobei zwischen Kathoden (14) und Anoden (16) benachbarter Brennstoffzellenstapel eine Bipolarplatte (20) angeordnet ist, und mindestens eine Messvorrichtung gemäß einem der vorangehenden Ansprüche vorgesehen ist.

12. Verfahren zur Bestimmung der elektrischen Potentialverteilung und/oder der Stromdichteverteilung an einer Elektrode, bei dem die Elektrode mit einer elektrischen Kontakteinrichtung kontaktiert wird, die elektrische Potentialverteilung auf einer ersten Messfläche und auf einer zweiten Messfläche, welche zu der ersten Messfläche beabstandet ist, an der elektrischen Kontakteinrichtung gemessen wird, und mit Hilfe der elektrischen Potentialtheorie die elektrische Potentialverteilung und/oder Stromdichteverteilung auf einer Kontaktfläche der elektrischen Kontakteinrichtung, welche der Elektrode zugewandt ist, berechnet wird.

13. Verfahren nach Anspruch 12, **dadurch gekennzeichnet, dass** die Potentialverteilung an der elektrischen Kontakteinrichtung stromlos gemessen wird.

14. Verfahren nach Anspruch 12 oder 13, **dadurch gekennzeichnet, dass** die elektrische Potentialverteilung an der Kontaktfläche der elektrischen Kontakteinrichtung mit Hilfe der Laplace-Gleichung berechnet wird und insbesondere aus der Potentialverteilung die Stromdichteverteilung berechnet wird.

15. Verfahren nach einem der Ansprüche 12 bis 14, **dadurch gekennzeichnet, dass** unter Zugrundelegung des ermittelten Potentialverlaufs und/oder der ermittelten Stromdichteverteilung die Elektrode oder ein Elektrodensystem überwacht und/oder gesteuert und/oder geregelt wird.

# Fig. 1

Fig. 2

EP 2 017 630 A2

Fig. 3

# Fig. 4

# Fig. 5

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- DE 10151601 B4
- DE 10316117 B3
- EP 1254376 B1
- DE 19750738 C1
- DE 10213478 A1
- DE 10213479 A1
- JP 61264683 B
- DE 2451961 A1